# EUROPEAN PATENT SPECIFICATION

(11) **EP 1 046 881 B1**
(45) Date of publication and mention of the grant of the patent: **29.10.2003**
(21) Application number: 00303185.3
(22) Date of filing: 14.04.2000
(51) Int. Cl.: G01B 11/27, B25J 13/02, H01J 37/317, H01L 21/00

(54) **Alignment and handover calibration with different hole shadows and ion implanter with e-chuck and gripper**
Ausrichtung und Übergabeeichung mit unterschiedlichen Lochschatten und Ionenimplantierer mit E-Halter und Greifer
Alignement et calibration de mise en place avec des ombres de trous différentes et implanteur ionique avec support électrostatique et pince

(30) Priority: 19.04.1999 GB 9908952
(43) Date of publication of application: 25.10.2000
(73) Proprietor: Applied Materials, Inc., Santa Clara, California 95054-3299 (US)
(72) Inventor: Mitchell, Robert John Clifford, Pulborough, RH20 2EE West Sussex (GB); Biddle, James, Haywards Heath, West Sussex RH16 1QZ (GB); Joyce, Ian R., Horsham, West Sussex RH13 6 ED (GB); Edwards, James Victor, Selsey, West Sussex P020 9DF (GB)
(74) Representative: Cross, Rupert Edward Blount

(56) References cited:
- DE-A- 4 302 434
- GB-A- 2 025 043
- US-A- 4 319 406

## Description

The present invention relates to a method and apparatus for detecting that two moveable members are correctly positioned relatively to one another (independent claims 1, 10, 11).

The invention has a particular application to an ion implantation apparatus in which a single wafer is transferred in a vacuum chamber from a loading mechanism such as loadlock to an electrostatic chuck (hereinafter referred to as an e-chuck) on a gripper arm. The gripper arm also retrieves the wafer from the e-chuck and returns it to the loadlock.

Typically, a robot which drives the gripper arm will have between two and four axes of movement. For example, EP 604066 discloses a gripper arm which is axially movable along a vertical axis and rotatable about the same axis.

The e-chuck will typically have several axes of movement, for example, as disclosed in WO 99/13488. In this case the arm which supports the e-chuck extends out of the vacuum chamber and is supported by a linear motion mechanism for reciprocably moving the e-chuck vertically so that the entire surface of a wafer on the e-chuck is scanned by a horizontally scanning ion beam. The linear motion mechanism itself is mounted so as to be rotatable about a horizontal tilt axis which allows the angle between the wafer and the ion beam to be varied. The e-chuck is further provided with a mechanism for rotating the wafer about an axis passing through a centre of the wafer and perpendicular to the plane of the wafer.

Although the mechanisms driving the gripper arm and the e-chuck are provided with encoders which allow them to be driven to a very precise position, the fact that there are so many axes of freedom means that, over time, the mechanisms may drift, particularly as components of the mechanisms start to wear. This results in an imprecise handoff between the gripper arm and e-chuck such that the wafers have to be slid over the surface of the e-chuck causing particulate contaminants on the underside of the wafer. Also, as the encoders cannot provide an absolute position reading they have to be calibrated before use. Such calibration is normally done manually, which can be particularly time consuming and requires a skilled operator.

According to the present invention there is provided an apparatus for detecting that two moveable members are correctly positioned relatively to one another in a predetermined position, the apparatus comprising a light source, a light sensor onto which light from the light source is projected, and a respective flag on each member which produces a characteristic shadow on the light detector when in the predetermined position, the characteristic shadows of the two flags being different from one another.

This apparatus will accurately verify the relative position of the two members, as both members are located with respect to the same light source. As optical sensors are being used, they provide an indication of the absolute position of the two members and are independent of the mechanism driving the two members.

Preferably, the flag on each member is a through hole, with the through hole on one member being larger than the through hole on the other, and wherein the centres of the through holes are aligned in the direction in which the light from the light source travels to the sensor when the members are in the predetermined position. The sensor is preferably a two dimensional position sensitive diode. The light source can be any collimated light source, but is preferably a class 1 modulated infra red laser as the sensor can distinguish between this and ambient light and it also satisfies the necessary safety requirements.

The present invention is particularly applicable to an ion implantation apparatus, wherein the first member is a gripper arm which transfers a wafer within a vacuum chamber from a loading position to a processing position and back, and the second member is an e-chuck on which the wafer is retained while it is scanned by the ion beam. In this case, the flags should be provided on the e-chuck and the gripper arm so as to have a fixed relationship with the wafer position to allow the position of the wafer to be determined easily from the sensor readings. Generally speaking, the e-chuck is brought to the handoff position before the gripper arm. Therefore, when the flags on the two members are provided by through holes, the diameter of the through hole associated with the e-chuck is greater than the diameter of the through hole associated with the gripper arm. When the light source and light sensor are mounted outside the vacuum chamber behind appropriately positioned windows they can be readily removed for maintenance or replacement without requiring access to the vacuum chamber.

When a gripper arm is used which has a pair of jaws which are moveable between open and closed configurations, the gripper arm may be provided with a third flag which produces a third characteristic signal on the light sensor when the gripper arm is in the predetermined position and its jaws are open, allowing the apparatus to determine the configuration of the gripper jaws.

According to a second aspect of the present invention, there is provided a method of detecting that two moveable members are correctly positioned relatively to one another at a predetermined position, the method comprising emitting a beam of light from a light source towards a light sensor, moving each member, so that a flag on each member produces a respective characteristic shadow on the light sensor when in the predetermined position, the characteristic shadows being different from one another, and detecting that the two members are in the correct alignment when both characteristic shadows are simultaneously recognised on the light sensor.

The present invention also extends to a method of calibrating an apparatus having a pair of moveable arms which are driveable to a handoff position to pass a component from one arm to the other, a position sensitive light sensor, and a light source emitting light towards the light sensor, wherein each arm has a flag which produces its own characteristic signal at the light sensor when interposed between the light source and the light sensor, the characteristic signals being different from one another, the method comprising the steps of scanning the first arm across the sensor, recording the readings produced by the first flag across the sensor, scanning the second arm across the sensor, recording the readings produced by the second flag across the sensor, and calculating from the two sets of readings the position where the two flags coincide which represents the handoff position.

This method allows for the automatic calibration of the handoff position which can be done in software. Further, precise positioning of the light source and sensor is unnecessary as any inaccuracies in their positioning are calibrated out using this method.

Preferably, the two moving arms are robot arms driven by one or more servo motors each having an encoder, and the method further comprises noting the encoder readings at the handoff position, and subsequently driving the robot arms to the positions derived from encoder readings at the handoff position, and detecting the signal produced by the sensor at this position. This method allows the position of the arms to be monitored, such that any drift in the position of these arms can be detected.

The present invention further encompasses an apparatus, comprising detecting apparatus according to the invention, for calibrating and controlling the handoff between a moveable member in the form of a gripper arm and a moveable member in the form of an electrostatic chuck in an ion implantation apparatus, the gripper arm and electrostatic chuck each being driven by one or more servo motors, the apparatus for calibrating and controlling further comprising a computer, an encoder on each servo motor for producing a signal relating to the position of the servo motor and providing this information to the computer, a connection between the computer and a drive mechanism of each servo motor for controlling the motion of each servo motor; the computer having a processor arranged to receive and store values indicative of signals from the encoders and sensor recorded when the gripper arm and electrostatic chuck are at a predetermined handoff position at which the flags, mounted on the gripper arm and electrostatic chuck each intercept a proportion of the light directed to the sensor and produce a respective characteristic signal at the sensor indicative of the fact that the gripper arm and electrostatic chuck are at the handoff position, the characteristic signals being different from one another,to subsequently output a signal to the drive mechanism of each servo motor to drive each servo motor to a position at which the reading from each encoder matches the stored value, and to record the signal from the sensor in this position and compare this value with the stored value.

Preferably the processor is further arranged to determine the drift of the gripper and electrostatic chuck by comparing the stored value of the sensor with each measured value. Preferably the processor is further arranged to alert an operator if the amount of drift detected exceeds a predetermined threshold.

An example of an ion implantation apparatus incorporating the method and apparatus of the present invention will now be described with reference to the accompanying drawings, in which:
Fig.1 is a schematic perspective view of the ion implantation apparatus to which the present invention is applied;
Fig. 1A is a diagrammatic view illustrating the various movements of the electrostatic chuck during operation of the ion implanter;
Fig.2 is a schematic perspective view illustrating the principles of the present invention;
Fig.3 is a plan view showing the gripper and e-chuck;
Fig.4 is a diagrammatic representation of the calibration process;
Fig.4A is a diagrammatic view showing the signal produced at the sensor during the calibration process; and
Fig.5 is a schematic diagram showing the controlling mechanism of the apparatus.

The vacuum chamber and e-chuck used in the present invention are similar to that disclosed in WO 99/13488, in terms of the scanning motion of the e-chuck.

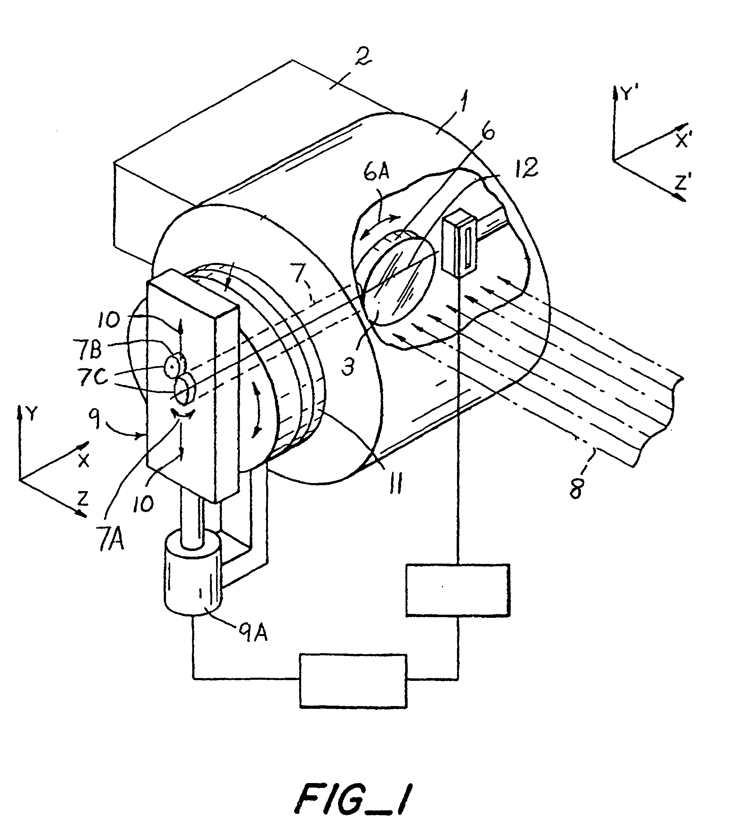

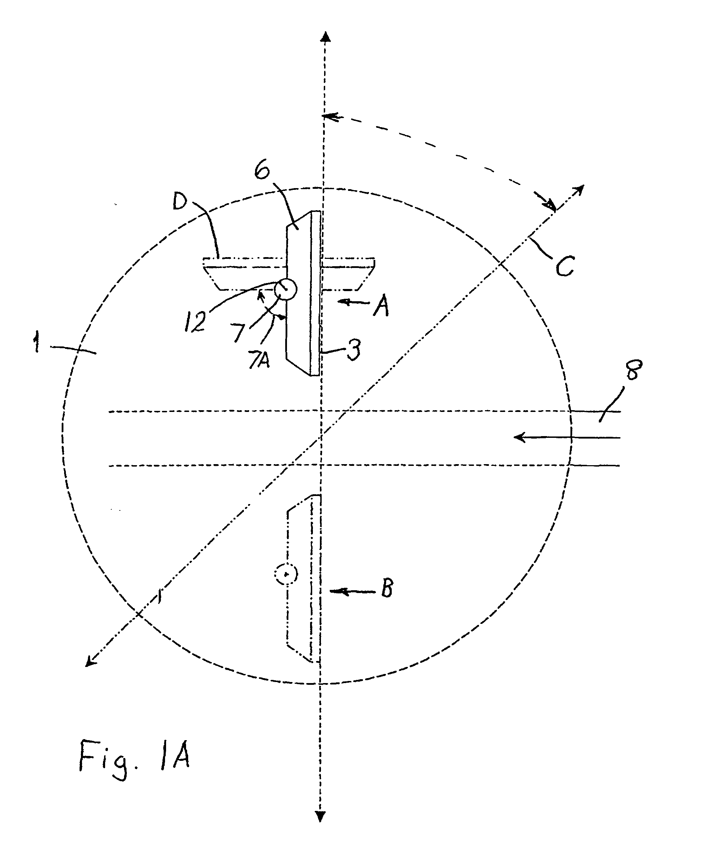

Fig.1 illustrates the vacuum chamber and e-chuck, and is similar in most respects to Fig.1 of WO 99/13488. The carousel for loading the wafers into the vacuum chamber has now been replaced by a loadlock 2 of known construction. It should, however, by appreciated that the carousel of WO 99/13488 can still be used with the present invention.

In this ion implantation apparatus, a wafer 3 is held in position on an e-chuck 6 which is supported at the end of a scan arm 7 and is scanned by a horizontally scanning ion beam 8 which is projected through a window in the vacuum chamber 1.

The scanning arm 7 extends through a vacuum seal in the vacuum chamber 1, and is mounted on a plate 9 which is linearly reciprocable in the direction of arrows 10 as shown in Fig.1 by a linear motor 9A. The plate is driven to move the e-chuck 6 vertically between the positions shown as A and B in Fig.1A. The plate 9 and motor 9A are mounted by a rotary bearing 11, allowing the e-chuck 6 to be tilted about a horizontal axis as shown at C in Fig.1A, thereby varying the angle at which ion beam 8 impinges on the wafer 3 during the scanning operation. The e-chuck 6 is also mounted so as to be rotatable about an axis passing through its centre and perpendicular to the plane of the wafer 3 as shown as arrow 6A in Fig.1.

As a development of the apparatus of WO 99/13488, the scan arm 7 is rotatably mounted to the plate 9 so as to be rotatable about its elongate axis 12 independently of the plate 9 and rotary bearing 11 as shown by arrow 7A in Fig.1. The arm is rotated by a motor 7B mounted on plate 9 via gears 7C. This extra degree of freedom allows the plate 9 to be driven to one end of its range of movement, ideally the upper end as shown as A in Fig. 1A, whereupon the arm 7 can be rotated through 90% about the axis 12, such that the e-chuck 6 is now in a horizontal loading configuration which is out of the plane of the beam 8 as shown at D in Fig. 1A.

This horizontal loading forms the subject of our co-pending U.S. Application No. 09/293,940 filed on the same day as the present application (US-B1-6 207 959 published 27,3,01).

An alternative mechanism where wafers are loaded into an e-chuck in a horizontal configuration forms the subject of a further co-pending U.K. Application No. 9908953.4 filed on the same day as the present application (GB-A-2 349 269 published 25,10,00). In this case a scanning arm with an e-chuck at one end is rotatably mounted at its other end to the outside of a hub so as to be rotatable about a first axis parallel to a line normal to the wafer bearing surface of the e-chuck. Reciprocating rotation through a limited angle about the first axis scans a wafer on the e-chuck through the ion beam. The hub itself is rotatable about a horizontal second axis perpendicular to the first axis, such that rotation of the hub about this second axis brings the e-chuck from its vertical scanning configuration into a horizontal loading configuration out of the plane of the ion beam. The present invention is equally applicable to loading a wafer on the e-chuck of this apparatus.

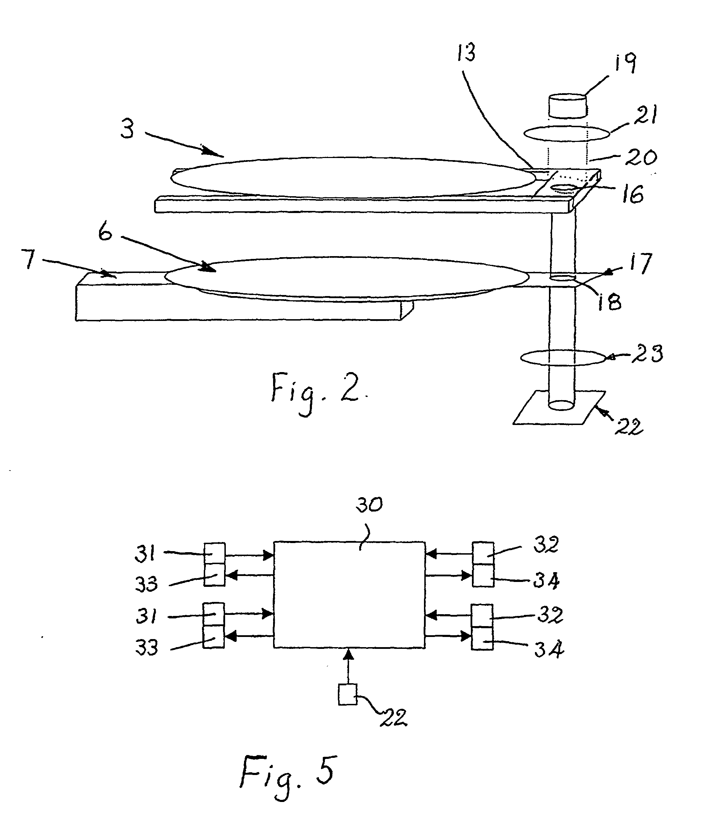

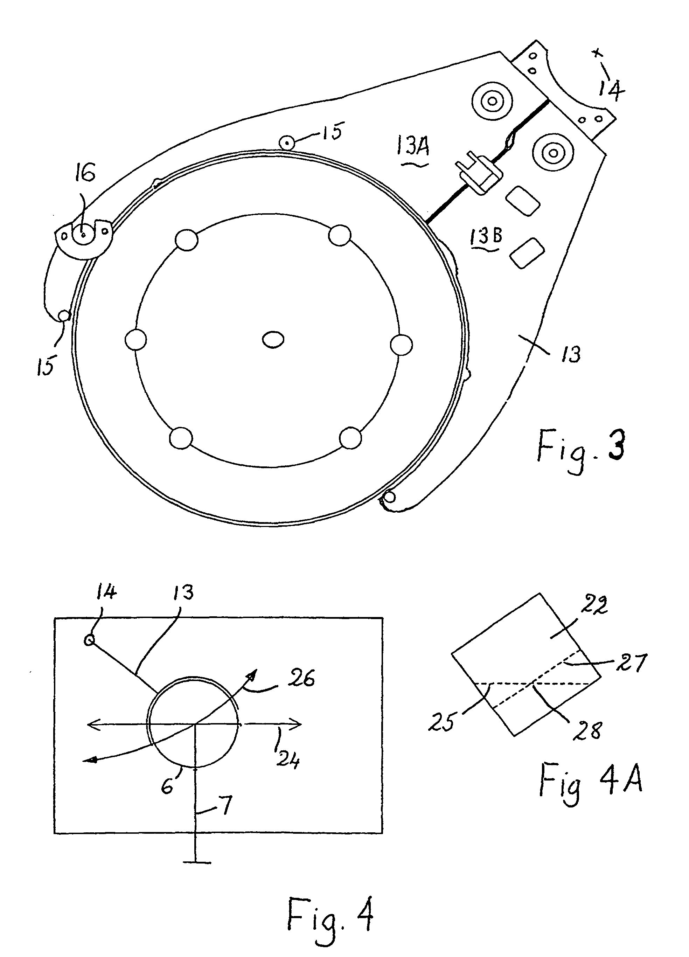

A device for conveying the wafers 3 from the loadlock 2 to the e-chuck 6 in its horizontal loading position will now be described with reference to Figs 2 and 3.

The subsequent description, refers to the e-chuck only in the horizontal loading position, but it should be appreciated that the scanning cperation of the wafer is as described in WO 99/13488.

As shown in Figs. 2 and 3, a gripper arm 13 is provided which is pivotable about a vertical axis 14 so as to transport a wafer 3 between the loading mechanism and a handoff position. The gripper arm 13 comprises a pair of jaws 13A, 13B which are pneumatically operable so as to open and close to pick up and set down the wafer 3 (as shown in outline in Fig.2). Three fingers 15 are provided around the inner periphery of the gripper to engage the edge of the wafer 3. The gripper arm 13 is provided with a through hole 16 having a 2mm diameter as shown in Fig.3 and as illustrated schematically in Fig.2.

The e-chuck 6 has a flange 17 which projects beyond the wafer receiving portion of the e-chuck and is provided with a through hole 18 which typically has a diameter of 3mm. The through hole 18 is shown schematically in Fig.2, and is not shown in Fig.3 as it is obscured behind the through hole 16 and the gripper arm 13A.

A collimated light source 19, such as a modulated infra-red laser, is provided in the outer wall of the vacuum chamber and projects the collimated beam of light 20 into the vacuum chamber through a window 21. A position sensitive two dimensional photodiode 22 is positioned in a wall of the chamber opposite to the light source 19 and receives light from the light source 19 through a window 23.

As can be seen from Fig. 2, with the gripper arm 13 out of the way, when the e-chuck 6 is moved into the predetermined position, flange 17 provides a flag which will intercept some of the light from the light source 19 thereby forming a characteristic shadow at the light sensor 22, and a resultant signal having a characteristic position and intensity will be detected at the light detector 22. Because the through hole 18 has a fixed relationship with the e-chuck 6, the absolute position of the e-chuck 6 is accurately known. This mechanism can also be used to ensure that the e-chuck 6 is in a horizontal plane as any deviation of the plane of the e-chuck from the horizontal will result in the signal detected by the sensor 22 having an oval, rather than a perfectly circular shape. The mechanism driving the scanning arm 7 can then be adjusted to return the chuck 6 to the correct horizontal orientation at which the sensor records a perfectly circular spot of light.

With the e-chuck 6, remaining in place, the gripper arm 13 is brought into position as shown in Fig.2. The portion of the gripper arm 13 defining the hole 16 itself provides a flag which intercepts more of the light than the flange 17 defining the hole 18 thereby producing a characteristic shadow at the light sensor so that the sensor 22 will detect a signal which indicates the same position as before, but at a reduced intensity. As the wafer 3 is gripped by the three fingers 15, it will be positioned at a fixed relationship with respect to the through hole 16. It is therefore possible to determine the exact position of the wafer 3, and to verify that this is now directly above the e-chuck 6.

The relative elevational separation between the wafer 3 and the e-chuck 6 can be determined using a further sensor. The gripper arm 13 can then be moved vertically along the axis 14 to lower the wafer onto position, the gripper arm 13 opens releasing the wafer 3. The gripper arm 13A is provided with a second through hole (not shown) having a smaller diameter (typically 1.5mm) than the first through hole. This second through hole will be brought into alignment with the through hole 18 in the e-chuck when the gripper arm opens. As a result of this, the sensor 22 will detect a signal of even lower intensity than that detected with the gripper arm closed, so that it can verify that the gripper arm has been correctly opened.

As the gripper arm 13 and e-chuck 6 are driven by robots having a number of axes of motion, each of which is driven by a servo motor having a rotary encoder, it is necessary to calibrate the apparatus prior to use. The calibration process will now be described with particular reference to Figs. 4 and 4A.

With the gripper arm 13 out of the way, the scan arm 7 is driven across the vacuum chamber in the direction of arrow 24. At this time, the e-chuck 6 is maintained in its horizontal configuration. This is achieved by rotating the rotary bearing 11 about its axis, while moving the plate 9 to keep the e-chuck at the correct height, and rotating the scan arm 7 about the axis 12 in order to maintain the e-chuck 6 in its horizontal orientation. This movement will produce a horizontal trace across the sensor 22 as represented schematically by line 25 in Fig.4A. This information is stored in the memory of a computer 30 as shown in Fig.5. The e-chuck 6 is moved out of the way and a similar process is repeated for the gripper arm 13, which is moved about axis 14 along the arc shown as arrow 26 in Fig. 4. This motion produces an arcuate trace on the sensor 22 shown as line 27 in Fig. 4A. This data is also stored in the memory of computer 30.

The computer 30 then calculates from this data the point 28 at which the two traces 25, 27 intersect. The values from the encoders 31 driving the gripper arm 13 and the encoders 32 driving the scan arm 7 are also recorded at this position.

During operation, the motors 33 driving the gripper arm 13 and the motors 34 driving the scan arm 7 are driven to the recorded values of the encoders 31, 32 necessary to bring the two arms to a position in which the through holes 16, 18 are above the handover position 28. At this position, as there is a fixed relationship between the through hole 16 and the wafer 3, and between the through hole 18 and the e-chuck 6, the wafer 3 will always be directly above the e-chuck 6. Each time the arms are driven to the handover position, the computer 30 checks the reading from the sensor 22 to verify that the two arms are indeed in the correct position. This allows any misalignment of the arm to be detected by the computer independently of the mechanism driving the two arms. A degree of drift can occur while still remaining in the tolerance allowed for the handoff position. This drift is monitored by the computer 30 as it provides useful diagnostic information.

## Claims

1. An apparatus for detecting that two moveable members (13, 7) are correctly positioned relatively to one another in a predetermined position, the apparatus comprising a light source (19), a light sensor (22) onto which light from the light source is projected, and a respective flag (16, 18) on each member (13, 7) which produces a respective characteristic shadow on the light sensor when in the predetermined position, the characteristic shadows of the two flags being different from one another.

2. An apparatus according to claim 1, wherein the flag on each member is a through hole (16, 18), with the through hole on one member being larger than the through hole on the other, and wherein the centres of the through holes are aligned in the direction in which the light from the light source travels to the sensor (22) when the members are in the predetermined position.

3. An apparatus according to claim 1 or claim 2, wherein the sensor (22) is a two dimensional position sensitive diode.

4. An apparatus according to any one of the preceding claims, wherein the light source (19) is a class 1 modulated infra red laser.

5. An ion implantation apparatus comprising the apparatus according to any one of the preceding claims, wherein the first member is a gripper arm (13) which transfers a wafer (3) within a vacuum chamber from a loading position to a processing position and back, and the second member is an e-chuck (6) on which the wafer is retained while it is scanned by an ion beam.

6. An ion implantation apparatus according to claim 5, wherein the flags (18, 16) on the e-chuck and the gripper arm have a fixed relationship with the wafer position.

7. An ion implantation apparatus according to claim 5 or claim 6, wherein the diameter of the through hole (18) associated with the e-chuck is greater than the diameter of the through hole (16) associated with the gripper arm.

8. An ion implantation apparatus according to any one of claims 5 to 7, wherein the light source (19) and light sensor (22) are mounted outside the vacuum chamber behind appropriately positioned windows.

9. An ion implantation apparatus according to any one of claims 5 to 8, wherein the gripper arm (13) is provided with a third flag which produces a third characteristic signal on the light sensor when the gripper arm is in the predetermined position and its jaws (13A, 13B) are open.

10. A method of detecting that two moveable members are correctly positioned relatively to one another at a predetermined position, the method comprising emitting a beam of light from a light source (19) towards a light sensor (22), moving each member, so that a flag (16, 18) on each member produces a respective characteristic shadow on the light sensor (22) when in the predetermined position, the characteristic shadows being different from one another, and detecting that the two members are in the correct alignment when both characteristic shadows are simultaneously recognised on the light sensor (22).

11. A method of calibrating an apparatus having a pair of moveable arms which are driveable to a handoff position to pass a component (3) from one arm (13) to the other (6), a position sensitive light sensor (22), and a light source (19) emitting light towards the light sensor, wherein each arm (13, 6) has a flag (16, 18) which produces its own characteristic signal at the light sensor when interposed between the light source (19) and the light sensor (22), the characteristic signals being different from one another, the method comprising the steps of scanning the first arm across the sensor, recording the readings produced by the first flag across the sensor, scanning the second arm across the sensor, recording the readings produced by the second flag across the sensor, and calculating from the two sets of readings the position where the two flags coincide which represents the handoff position.

12. A method according to claim 11, wherein the two moveable arms are robot arms driven by one or more servo motors each having an encoder, and the method further comprises noting the encoder readings at the handoff position, and subsequently driving the robot arms to the positions derived from encoder readings at the handoff position, and detecting the signal produced by the sensor at this position.

13. An apparatus comprising apparatus according to anyone of Claims 1 to 4 for calibrating and controlling the handoff between a moveable member in the form of a gripper arm (13) and a moveable member in the form of an electrostatic chuck (6) in an ion implantation apparatus, the gripper arm and electrostatic chuck each being driven by one or more servo motors (33), the apparatus for calibrating and controlling further comprising a computer (30), an encoder (31, 32) on each servo motor (33) for producing a signal relating to the position of the servo motor and providing this information to the computer, a connection between the computer and a drive mechanism of each servo motor for controlling the motion of each servo motor, the computer having a processor arranged to receive and store values indicative of signals from the encoders and sensor recorded when the gripper arm and electrostatic chuck are at a predetermined handoff position at which the flags mounted on the gripper arm and electrostatic chuck each intercept a proportion of the light directed to the sensor and produce a respective characteristic signal at the sensor indicative of the fact that the gripper arm and electrostatic chuck are at the handoff position, the characteristic signals being different from one another, to subsequently output a signal to the drive mechanism of each servo motor to drive each servo motor to a position at which the reading from each encoder matches the stored value, and to record the signal from the sensor in this position and compare this value with the stored value.

14. An apparatus according to claim 13, wherein the processor is further arranged to determine the drift of the gripper arm (13) and electrostatic chuck (6) by comparing the stored value of the sensor with each measured value.

15. An apparatus according to claim 14, wherein the processor is further arranged to alert an operator if the amount of drift detected exceeds a predetermined threshold.

## Patentansprüche

1. Vorrichtung zum Feststellen, dass zwei bewegliche Elemente (13, 7) genau bezüglich einander in einer vorgegebenen Stellung genau positioniert sind, wobei die Vorrichtung eine Lichtquelle (19), einen Lichtsensor (22), auf den Licht aus der Lichtquelle projiziert wird, und jeweils einen Lichtabdeckschirm (16, 18) an jedem Element (13, 7) aufweist, der jeweils einen charakteristischen Schatten auf dem Lichtsensor erzeugt, wenn er sich in der vorgegebenen Position befindet, wobei die charakteristischen Schatten der beiden Lichtabdeckschirme voneinander verschieden sind.

2. Vorrichtung nach Anspruch 1, bei welcher der Lichtabdeckschirm an jedem Element ein durchgehendes Loch (16, 18) ist, wobei das durchgehende Loch an dem einen Element größer ist als das durchgehende Loch an dem anderen Element und die Mitten der durchgehenden Löcher in der Richtung fluchtend ausgerichtet sind, in der sich das Licht von der Lichtquelle zum Sensor (22) bewegt, wenn sich die Elemente in der gegebenen Position befinden.

3. Vorrichtung nach Anspruch 1 oder Anspruch 2, bei welcher der Sensor (22) eine zweidimensionale lageempfindliche Diode ist.

4. Vorrichtung nach einem der vorhergehenden Ansprüche, bei welcher die Lichtquelle (19) ein modulierter Infrarotlaser der Klasse 1 ist.

5. lonenimplantieranordnung, mit der Vorrichtung nach einem der vorhergehenden Ansprüche, wobei das erste Element ein Greifarm (13) ist, der einen Wafer (3) in einer Vakuumkammer aus einer Beladeposition in eine Behandlungsposition und zurück überführt, und das zweite Element ein E-Halter (6) ist, an dem der Wafer gehalten wird, während er von einem lonenstrahl überstrichen wird.

6. lonenimplantieranordnung nach Anspruch 5, bei welcher die Lichtabdeckschirme (18, 16) an dem E-Halter und an dem Greifarm eine festgelegte Beziehung zu der Waferposition haben.

7. lonenimplantieranordnung nach Anspruch 5 oder Anspruch 6, bei welcher der Durchmesser des durchgehenden Lochs (18), das dem E-Halter zugeordnet ist, größer ist, als der Durchmesser des durchgehenden Lochs (16), das dem Greifarm zugeordnet ist.

8. lonenimplantieranordnung nach einem der Ansprüche 5 bis 7, bei welcher die Lichtquelle (19) und der Lichtsensor (22) außerhalb der Vakuumkammer hinter geeignet positionierten Fenstern angebracht sind.

9. lonenimplantieranordnung nach einem der Ansprüche 5 bis 8, bei welcher der Greifarm (13) mit einem dritten Lichtabdeckschirm versehen ist, der an dem Lichtsensor ein drittes charakteristisches Signal erzeugt, wenn der Greifarm sich in der gegebenen Position befindet und seine Haltebacken (13A, 13B) offen sind.

10. Verfahren zum Feststellen, dass zwei bewegliche Elemente bezüglich einander in einer gegebenen Stellung genau positioniert sind, wobei bei dem Verfahren ein Lichtstrahl von einer Lichtquelle (19) zu einem Lichtsensor (22) hin emittiert wird, jedes Element so bewegt wird, dass ein Lichtabdeckschirm (16, 18) an jedem Element jeweils einen charakteristischen Schatten auf dem Lichtsensor (22) erzeugt, wenn es sich in der gegebenen Position befindet, wobei sich die charakteristischen Schatten voneinander unterscheiden, und erfasst wird, dass sich die zwei Elemente in der genau fluchtenden Ausrichtung befinden, wenn beide charakteristische Schatten gleichzeitig auf dem Lichtsensor (22) erkannt werden.

11. Verfahren zum Eichen einer Vorrichtung, die ein Paar von beweglichen Armen, die zwangsweise in eine Übergabeposition bewegbar sind, um ein Teil (3) von einem Arm (13) zum anderen (6) zu überführen, einen lageempfindlichen Lichtsensor (22) und eine Lichtquelle (19) aufweist, die Licht zu dem Lichtsensor hin emittiert, wobei jeder Arm (13, 6) einen Lichtabdeckschirm (16, 18) hat, der ein eigenes charakteristisches Signal an dem Lichtsensor erzeugt, wenn er zwischen der Lichtquelle (19) und dem Lichtsensor (22) angeordnet ist, wobei die charakteristischen Signale voneinander verschieden sind, und wobei das Verfahren die Schritte aufweist, dass der erste Arm den Sensor überstreicht, dass die Messwerte aufgezeichnet werden, die von dem ersten Lichtabdeckschirm quer über den Sensor erzeugt werden, dass der zweite Arm den Sensor überstreicht, dass die Messwerte aufgezeichnet werden, die von dem zweiten Lichtabdeckschirm quer über den Sensor erzeugt werden, und dass aus den beiden Sätzen von Messwerten, die Position errechnet wird, bei der die beiden Lichtabdeckschirme koinzidieren, was die Übergabeposition darstellt.

12. Verfahren nach Anspruch 11, bei welchem die beiden beweglichen Arme Robotarme sind, die von einem oder mehreren Servomotoren angetrieben werden, von denen jeder eine Codiereinrichtung hat, wobei bei dem Verfahren weiterhin die Codiereinrichtungsmesswerte an der Übergabeposition aufgezeichnet und darauf folgend die Robotarme zwangsweise in die Positionen bewegt werden, die aus den Codiereinrichtungsmesswerten an der Übergabeposition abgeleitet werden, und das Signal gemessen wird, das von dem Sensor in dieser Position erzeugt wird.

13. Einrichtung mit einer Vorrichtung nach einem der Ansprüche 1 bis 4, zum Eichen und Steuern der Übergabe zwischen einem beweglichen Element in Form eines Greifarms (13) und einem beweglichen Element in Form eines elektrostatischen Halters (6) in einer lonenimplantieranordnung, wobei der Greifarm und der elektrostatische Halter von einem oder mehreren Servomotoren (33) angetrieben werden und die Einrichtung zum Eichen und Steuern weiterhin einen Rechner (30), eine Codiereinrichtung (31, 32) an jedem Servomotor (33) zum Erzeugen eines Signals, das sich auf die Position des Servomotors bezieht, und zur Bereitstellung dieser Information für den Rechner sowie eine Verbindung zwischen dem Rechner und einem Antriebsmechanismus eines jeden Servomotors aufweist, um die Bewegung eines jeden Servomotors zu steuern, der Rechner einen Prozessor hat, der so angeordnet ist, dass er Werte empfängt und speichert, die für Signale aus den Codiereinrichtungen und dem Sensor stehen, die aufgezeichnet werden, wenn sich der Greifarm und der elektrostatische Halter in einer gegebenen Übergabeposition befinden, bei der die an dem Greifarm und dem elektrostatischen Halter angebrachten Lichtabdeckschirme einen Anteil des Lichts auffangen, das zu dem Sensor gerichtet ist, und jeweils ein charakteristisches Signal an dem Sensor erzeugen, das für die Tatsache steht, dass sich der Greifarm und der elektrostatische Halter in der Übergabeposition befinden, wobei die charakteristischen Signale voneinander verschieden sind, wonach ein Signal an den Antriebsmechanismus eines jeden Servomotors abgeben wird, um jeden Servomotor in eine Position zu bewegen, in der der Messwert aus der Codiereinrichtung dem gespeicherten Wert entspricht, und das Signal aus dem Sensor in dieser Position aufgezeichnet und dieser Wert mit dem gespeicherten Wert verglichen wird.

14. Einrichtung nach Anspruch 13, bei welcher der Prozessor weiterhin angeordnet ist, um die Abweichung des Greifarms (13) und des elektrostatischen Halters (6) zu bestimmen, indem der gespeicherte Wert des Sensors mit jedem gemessenen Wert verglichen wird.

15. Einrichtung nach Anspruch 14, bei welcher der Prozessor weiterhin angeordnet ist, um eine Bedienungsperson zu warnen, wenn die Größe der festgestellten Abweichung eine vorher festgelegte Schwelle überschreitet.

## Revendications

1. Appareil pour détecter le positionnement correct de deux éléments mobiles (13, 7) l'un par rapport à l'autre dans une position prédéterminée, l'appareil comportant une source de lumière (19), un capteur de lumière (22) sur lequel de la lumière provenant de la source de lumière est projetée, et un volet respectif (16, 18) sur chaque élément (13, 7) qui produit une ombre caractéristique respective sur le capteur de lumière lorsque l'élément est dans la position prédéterminée, les ombres caractéristiques des deux volets étant différentes l'une de l'autre.

2. Appareil selon la revendication 1, dans lequel le volet sur chaque élément présente un trou traversant (16, 18), le trou traversant sur un élément étant plus grand que le trou traversant sur l'autre élément, et dans lequel les centres des trous traversants sont alignés dans la direction dans laquelle la lumière se déplace de la source de lumière vers le capteur 22 lorsque les éléments sont dans la position prédéterminée.

3. Appareil selon la revendication 1 ou la revendication 2, dans lequel le capteur (22) est une diode sensible à une position dans deux dimensions.

4. Appareil selon l'une quelconque des revendications précédentes, dans lequel la source de lumière (19) est un laser à infrarouge modulé de classe 1.

5. Appareil d'implantation ionique comportant l'appareil selon l'une quelconque des revendications précédentes, dans lequel le premier élément est un bras de préhension (13) qui transfère une tranche (3) à l'intérieur d'une chambre à vide d'une position de chargement à une position de traitement et en retour, et le second élément est un plateau de serrage électrostatique (6) sur lequel la tranche est retenue tout en étant balayée par un faisceau ionique.

6. Appareil d'implantation ionique selon la revendication 5, dans lequel les volets (18, 16) sur le plateau de serrage électrostatique et le bras de préhension ont une relation fixe avec la position de la tranche.

7. Appareil d'implantation ionique selon la revendication 5 ou la revendication 6, dans lequel le diamètre du trou traversant (18) associé au plateau de serrage électrostatique est plus grand que le diamètre du trou traversant (16) associé au bras de préhension.

8. Appareil d'implantation ionique selon l'une quelconque des revendications 5 à 7, dans lequel la source de lumière (19) et le capteur de lumière (22) sont montés à l'extérieur de la chambre à vide, en arrière de fenêtres positionnées de façon appropriée.

9. Appareil d'implantation ionique selon l'une quelconque des revendications 5 à 8, dans lequel le bras de préhension (13) est pourvu d'un troisième volet qui produit un troisième signal caractéristique sur le capteur de lumière lorsque le bras de préhension est dans la position prédéterminée et que ses mâchoires (13a, 13b) sont ouvertes.

10. Procédé de détection du positionnement correct de deux éléments mobiles l'un par rapport à l'autre dans une position prédéterminée, le procédé comprenant l'émission d'un faisceau de lumière depuis une source de lumière (19) vers un capteur de lumière (22), le déplacement de chaque élément afin qu'un volet (16, 18) sur chaque élément produise une ombre caractéristique respective sur le capteur de lumière (22) lorsque l'élément est dans la position prédéterminée, les ombres caractéristiques étant différentes l'une de l'autre, et la détection du fait que les deux éléments sont dans l'alignement correct lorsque les deux ombres caractéristiques sont reconnues simultanément sur le capteur de lumière (22).

11. Procédé de calibrage d'un appareil ayant deux bras mobiles qui peuvent être entraînés vers une position dégagée pour le passage d'un composant (3) d'un bras (13) à l'autre bras (6), un capteur de lumière (22) sensible à la position et une source de lumière (19) émettant de la lumière vers le capteur de lumière, dans lequel chaque bras (13, 6) comporte un volet (16, 18) qui produit son propre signal caractéristique au capteur de lumière lorsqu'il est interposé entre la source de lumière (19) et le capteur de lumière (22), les signaux caractéristiques étant différents l'un de l'autre, le procédé comprenant les étapes qui consistent à amener le premier bras à effectuer un balayage sur le capteur, à enregistrer les valeurs lues produites par le premier volet sur le capteur, à amener le second bras à balayer le capteur, à enregistrer les valeurs lues produites par le second volet sur le capteur, et à calculer à partir des deux ensembles de valeurs lues la position où les deux volets coïncident, laquelle représente la position d'écartement.

12. Procédé selon la revendication 11, dans lequel les deux mobiles sont des bras de robot entraînés par un ou plusieurs servomoteurs ayant chacun un codeur, et le procédé comprend en outre le fait de relever les valeurs lues des codeurs dans la position d'écartement, et d'entraîner ensuite les bras de robot vers les positions dérivées des valeurs lues des codeurs dans la position d'écartement, et la détection du signal produit par le capteur dans cette position.

13. Appareil comprenant l'appareil selon l'une quelconque des revendications 1 à 4, pour le calibrage et la commande de l'écartement entre un élément mobile sous la forme d'un bras de préhension (13) et un élément mobile sous la forme d'un plateau de serrage électrostatique (6) dans un appareil d'implantation ionique, le bras de préhension et le plateau de serrage électrostatique étant entraînés chacun par un ou plusieurs servomoteurs (33), l'appareil pour le calibrage et la commande comportant en outre un ordinateur (30), un codeur (31, 32) sur chaque servomoteur (33) pour la production d'un signal associé à la position du servomoteur et la fourniture de cette information à l'ordinateur, une connexion entre l'ordinateur et un mécanisme d'entraînement de chaque servomoteur pour commander le mouvement de chaque servomoteur, l'ordinateur ayant un processeur agencé de façon à recevoir et stocker des valeurs représentatives de signaux provenant des codeurs et du capteur enregistrées lorsque le bras de préhension et le plateau de serrage électrostatique sont dans une position prédéterminée d'écartement dans laquelle les volets montés sur le bras de préhension et le plateau de serrage électrostatique interceptent chacun une proportion de la lumière dirigée vers le capteur et produisent un signal caractéristique respectif au capteur représentatif du fait que le bras de préhension et le plateau de serrage électrostatique sont dans la position d'écartement, les signaux caractéristiques étant différents l'un de l'autre, pour délivrer ensuite en sortie un signal au mécanisme d'entraînement de chaque servomoteur afin d'entraîner chaque servomoteur jusqu'à une position dans laquelle la valeur lue sur chaque codeur concorde avec la valeur stockée, et pour enregistrer le signal provenant du capteur dans cette position et comparer cette valeur à la valeur stockée.

14. Appareil selon la revendication 13, dans lequel le processeur est en outre agencé pour déterminer la dérive du bras de préhension (13) et du plateau de serrage électrostatique (6) en comparant la valeur stockée du capteur à chaque valeur mesurée.

15. Appareil selon la revendication 14, dans lequel le processeur est en outre agencé pour avertir un opérateur dans le cas où l'amplitude de la dérive détectée dépasse un seuil prédéterminé.
